# EUROPEAN PATENT APPLICATION

(11) **EP 0 619 380 A1**
(43) Date of publication of application: **12.10.1994**
(21) Application number: 94830145.2
(22) Date of filing: 28.03.1994
(51) Int. Cl.: C23C 14/56, C23C 14/50, C23C 14/34, C23C 14/12

(54) **Thin film deposition apparatus and process utilizing PECVD and sputtering**

(30) Priority: 06.04.1993 IT RM930216
(71) Applicant: CE.TE.V. CENTRO TECNOLOGIE DEL VUOTO, I-61067 Carsoli (AQ) (IT)
(72) Inventor: Misiano, Carlo, I-00161 Roma (IT); Simonetti, Enrico, I-00146 Roma (IT); Taglioni, Giovanni, I-00019 Tivoli (Roma) (IT)

(57) **Abstract**

Thin film deposition apparatus, utilising PECVD, sputtering technologies, etc., essentially constituted by a chamber (6) equipped with one or more electrodes (9) and respective counter-electrodes (8), screen (7), gas supply-lines (15), one or more magnetron sputtering cathodes; said chamber being provided with a rotating device loading substrates (12) able to capsize 180 degrees objects to treat. Said chamber can have polygonal, circular, etc. geometry, provided to consent installation of one or more kinds of sources. The invention consents, in a single vacuum cycle, the deposition of hardening and anti- reflecting layers on plastic material and it does not need frequent recharges. Technical field of the invention: vacuum techniques, thin film deposition; industrial application; lens coatings for ophthalmic, photooptical instruments, electronic semiconductors components, for civil and military areas.

## Description

The invention relates a thin film deposition apparatus, mainly dedicated to the ophthalmic field particularly to field of plastic material substrates. It makes possible to effect more than one treatment, that is, many thin film depositions can be effected in a single vacuum cycle. For example the deposition of a hardening layer on plastic material together with optic interferencial treatments, for example antireflecting treatments.

Depositions on both substrate sides are provided by this new technique in accordance with the sequential process steps:
- layer hardening treatment;
- optical treatment;
- water-repellent and anti-dirty treatments to depose on the anti-reflecting layer by a PECVD process.

The invention lays in the Scientific and technique context of the thin film deposition.

It gives many capabilities, above all in the ophthalmic sector, for instance in lens treatment, laser instruments and so on; for optical cars equipment and always when processes by PECVD techniques are requested.

In addition, the invention can be utilized for the manufactures of electronic components, semiconductors, microcircuits and similar, to be applied in civil and military areas.

It is the principal object of the present invention to improve this kind of techniques. In fact, costs and workmanship are reduced so as coatings become easier to make.

Until now in fact operators, to realise a process, had to make a series of actions, partially automatic, in which they had to reload lens or substrates on many and different looms, and then effect cleaning processes, layout of resins processes, drying processes, and so on.

All these operations requested, additionally, the intervention of aspirant hoods. In fact the operator was exposed to solvents and resins vapours which are noxious, as known.

In the last years there was the trend to realise optical components by plastic materials, for example CR39, known to the skilled in the art, greatly destined to the ophthalmic. In addition optical components in plastic material were going to be diffused in commercial and Scientific sectors.

However optical components in plastic material involved not negligible inconveniences, for ex.:
- Insufficient superficial hardness, which makes the substrate surface vulnerable to the abrasions with subsequent implication of the transparency;
- Sensibility to the heat which strongly decreases the use in technological processes for optical and thin films coatings.
- Dilatation coefficient which is greater in respect with that in the inorganic material, usually employed to effect optical and thin film coating.

Currently, some of these inconveniences are partially resolved applying lacquer and immersion processes, for hardening the sub-strates surface, and making thin film depositions almost cold with traditional thermic evaporation integrated with ionic bombardment.

These processes, however, often produced coatings which rapidly deteriorated, and/or with adverse environmental conditions.

Hardening processes more innovative can be found in the market, even based on the PECVD technique, for instance the process utilized at Balzers (Lichtenstein) and deposition for antireflex coating, plasma assisted.

For example. in processes realised by Laybold, and OCLI (U.S.A.), the technique of sputtering magnetron, ionic gun assisted, has been adopted with unsatisfactory results as shown in the following.

It is in the Inventors opinion that the single solution, near to their invention is that described in the patent No. 0502385A dated 22.2.92 filed by Balzers, Inventor Zimmermann, as said above. It is substantially different from the invention here presented. In fact the Balzers invention, thin film optical interferencial deposition is realised by evaporation from thermic source, with all connected limits.

With this method, that is with not very thick films, as in the description, the inconveniences are: insufficient hardness, insufficient durability, insufficient adherence.

This solution has been reported for comparison (Fig. E) with the invention here presented. It is easy to ascertain that the vacuum apparatus configuration is certainly traditional and of insufficient industrial applicability, if compared with the present patent application.

This invention then, resolves all the aforesaid inconveniences, as the requested coating operations are effected in the vacuum and in only one cycle, and hardening processes and thin film optical deposition processes, on both the surfaces, are effected by capsizing the components to trait by means of a system described in the following.

It is important to underline that with this new process the operator is not exposed to solvents and resins vapours. Consequently it is not necessary to equip the apparatus with aspirant hoods.

This characteristic is certainly important as it involves the operator health, and so represents another advantage in respect of the techniques utilized till now.

All this advantages make the process much more cheap in respect of the preceded solutions.

The present solution, argument of the present patent application, combines in a single apparatus the PECVD technique to realise hardening surfacing substrate and reactive sputtering magnetron to obtain antireflecting coating. In conclusion, to effect in a single process both hardness and antireflecting treatments on both sides, is the most important aspect of the invention.

Obviously, all the operations presented in the process can be automated with a qualified control software system applied to the apparatus.

It is evident that the possibility to effect a series of coatings in a single time, and on both the surfaces, represents a reduction of cost and time, which approximately could be quantified in 50 per cent, in respect of the known techniques. In addition, for this kind of processes a frequent recharge of deposition sources is not necessary because in one case the material is supplied with the flow atmosphere (PECVD). In the other cases the material constituting the cathode endures for hundred and hundred processes (sputtering).

It is consequent that the process presented in this patent application, is really suitable to be employed as a highly productive system, much more in respect of the known technologies.

In Fig. E, one of the known technique, it can be seen that they can treat only one substrate by time, on the contrary, the apparatus presented can make contemporary more coatings.

The characteristics of the films obtained by sputtering, relatively to the adherence, resistance to abrasives, hardness and resistance to the environmental agents are decidedly better than those obtainable throw thermic evaporation even ions assisted ones, thing strictly connected with greater energy of deposited particles.

The above and other objects, features and advantages of the present invention will become more readily apparent from the following description, reference being made to the accompanying drawing in which:

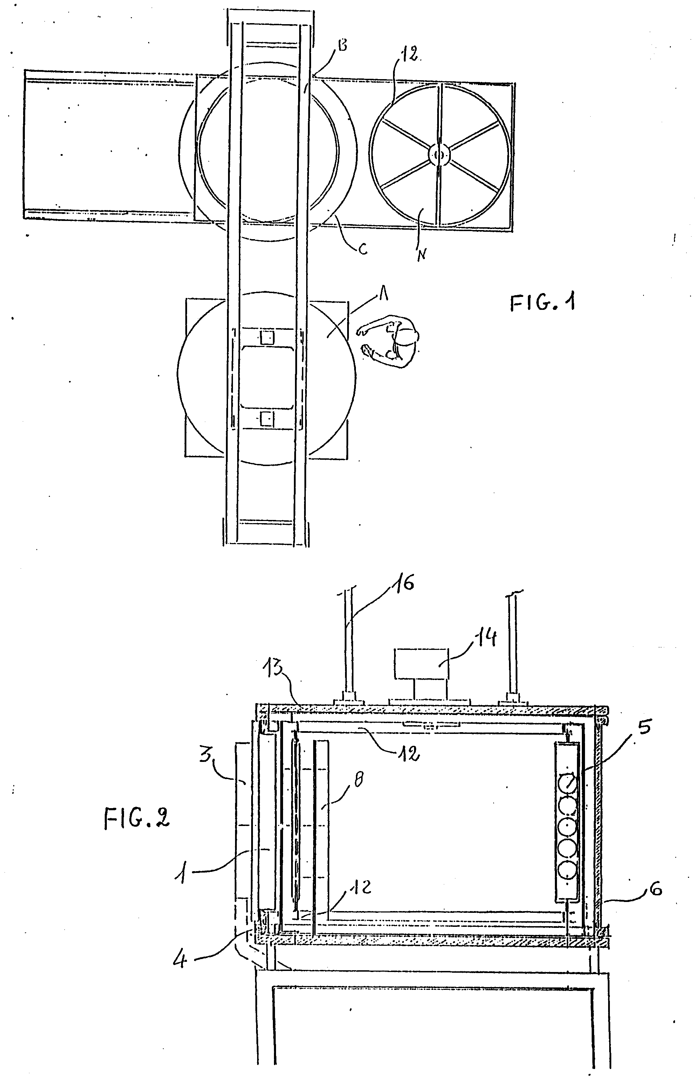

Fig. 1 is a view of the apparatus:
   A deposition apparatus;
   B apparatus cover lifting system;
   13 apparatus cover containing the rotating device canying substrates;
   N placing accessible by the cover containing the rotating element;
   12 a rotating element;.
Fig. 2 is a cross section view of the chamber:
   1 electrodes;
   2 electrode bracket flanges
   3 adapting net;
   4 access door for sources and maintenance;
   5 carrying substrates panel;
   8 counter-electrodes;
   12 element carrying substrates;
   13 apparatus cover;
   14 engine for element carrying substrates rotation;
   16 cover apparatus support.

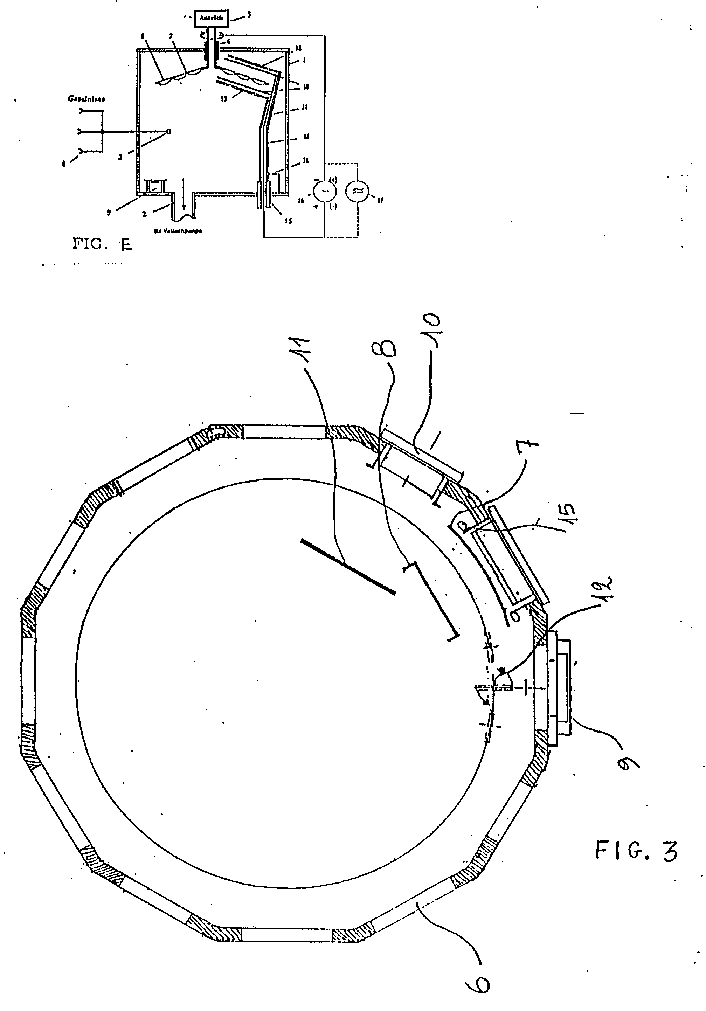

Fig. 3 is a view of the chamber:
   6 chamber;
   7 electrode PECVD screen;
   8 counter-electrodes;
   9 PECVD electrodes ;
   10 sputtering magnetron cathode;
   11 screen;
   12 rotating element carrying substrates;
   15 process gas supply-line.

Fig. E is a deposition chamber of the aforementioned European Patent, here reported for comparison with the present invention.

The apparatus configuration, is one of the most significant aspects of the invention. It can be realised in many ways, by any configuration.

The Inventors privileged a polygonal configuration. So that the substrates can be installed in front of many sources which can be disposed in any side of the chamber, in continuous movement. It can be equipped with a cathodes 10, screens 7, electrodes 8, 9, etc.

Fig. 3, is to be considered the most important.

The apparatus, essentially (Fig.3), is constituted by a chamber 6, one (or more) a rotating device carrying substrates 12, able to capsize the carrying substrates; by PECVD electrodes 9, PECVD counter-electrodes 8, screens 7 for the sources isolation.

The hardening process, which is one of the realisable processes, is going to be described:
a) cleaning the substrate, preferably by isopropyl alcohol, breezing afterwards by Nitrogen dry;
b) introducing substrates into the chamber;
c) vacuuming the chamber by a pumping device (for a PECVD process);
d) lighting discharge for some minutes;
e) introducing gas, preferably organosylan, through an aperture on the line in the direction of the chamber (6);
f) maintaining the discharge up to attaining the desired thickness of sediment;
g) inserting O₂ during lighting discharge, to obtain the hardening by a line provided with a fluxmeter with always greater concentration, such to pass, in continuous motion, from inorganic to organic layer as well as to make the structure elastic and resistant;
h) closing the vacuuming line in the chamber (6) of PECVD process and opening the valve which connects the high vacuum pumping unit with said chamber;
i) inserting process gas, for instance Argon +O₂, in the chamber (6);
l) feeding the power discharge by a RF generator stabilising processes parameters;
m) deposing high refraction index material;
n) deposing low refraction index material;
o) repeating n) and m) until the reflecting layer is correctly effected;
p) capsizing substrates by the rotating device after closing the high vacuum valve and then inlet process gas;
q) restarting again with a new deposition cycle from point a).

The deposition plant and respective processes, for which a patent is requested, are applying with success in any industry producing compatible products for its characteristics of quickness in obtaining coatings, for saving workmanship for the excellent conditions in which operators work. For the best quality of the product, the apparatus can be utilized in search centres and anywhere PECVD and PVD, sputtering etc. processes are requested.

## Claims

1. Thin films deposition apparatus, preferably utilising PECVD and sputtering techniques, and respective processes, characterised by the fact to be essentially constituted by a chamber (6), preferably polygonal, provided with electrodes screen PECVD (7), counter-electrodes PECVD (8), electrodes PECVD (9), magnetron sputtering cathodes (10), screens (11), process gas supply-lines (15), capsizing carrying substrates support (12).

2. Thin films deposition apparatus. preferably utilising PECVD and sputtering techniques, and respective processes, as for claim 1, characterised by the fact that said chamber (6) preferably polygonal can be realised in any configuration.

3. Thin films deposition apparatus, preferably utilising PECVD and sputtering techniques, and respective processes, as for claim 1, characterised by the fact that the carrying substrates support (12) can rotate on itself, keeping substrates in the same position during the different depositions.

4. Thin films deposition apparatus, preferably utilising PECVD and sputtering techniques, and respective processes, as for claims 1, 2, 3, characterised by the fact one of the coating processes, the hardening one, is realised as in the following:
a) cleaning the substrate, preferably by isopropyl alcohol, breezing afterwards by nitrogen dry;
b) introducing substrates into the chamber;
c) vacuuming the chamber by the means of pumping unit (for a PECVD process);
d) lighting discharge for some minutes;
e) introducing gas, preferably organosylan, through an aperture on the line in the direction of the chamber (6);
f) maintain the discharge up to attaining the desired thickness of sediment;
g) inserting O₂ during lighting discharge, to obtain the hardening by a line provided with a fluxmeter with always greater concentration, such to pass, in continuous motion, from inorganic to organic layer as well as to make the structure elastic and resistant;
h) closing the vacuuming line in the chamber (6) of PECVD process and opening the valve which connects the high vacuum pumping unit with said chamber;
i) inserting process gas, for instance Argon +O₂;
l) feeding the power discharge by a RF generator stabilising processes parameters;
m) deposing high refraction index material;
n) deposing low refraction index material;
o) repeating m), n) until reflecting layers are correctly made;
p) capsizing substrates by the rotating device after closing the high vacuum valve and then inlet process gas;
q) restarting again with a new deposition cycle from point a).

5. Thin films deposition apparatus, utilising preferably for PECVD and sputtering techniques, as for claims 1 to 4, characterised by the fact to be applied essentially in the manufacture field of ophthalmic lens, and in all fields where PECVD and sputtering processes are requested.

6. Thin films deposition apparatus, preferably utilising PECVD and sputtering techniques, and respective processes, as for the above claims, characterised by the fact to be provided with a computerised control system.
